# EUROPÄISCHE PATENTSCHRIFT

(11) **EP 0 827 608 B1**
(45) Veröffentlichungstag und Bekanntmachung des Hinweises auf die Patenterteilung: **11.11.1998**
(21) Anmeldenummer: 96919576.7
(22) Anmeldetag: 23.05.1996
(51) Int. Cl.: G06F 11/273, G01R 31/28

(54) **VERFAHREN ZUR RECHNERGESTÜTZTEN MESSUNG UND PRÜFUNG VON ELEKTRISCHEN SCHALTUNGEN, INSBESONDERE VON ELEKTRONISCHEN BAUGRUPPEN, UND PRÜFPLATZ ZUR DURCHFÜHRUNG DES VERFAHRENS**
PROCESS FOR THE COMPUTER-ASSISTED MEASUREMENT AND TESTING OF ELECTRIC CIRCUITS, ESPECIALLY ELECTRONIC MODULES, AND TESTING STATION FOR IMPLEMENTING THE PROCESS
PROCEDE DE MESURE ET DE VERIFICATION ASSISTE PAR ORDINATEUR DE CIRCUITS ELECTRIQUES, NOTAMMENT DE MODULES ELECTRONIQUES, ET POSTE DE VERIFICATION POUR LA MISE EN OEUVRE DUDIT PROCEDE

(30) Priorität: 23.05.1995 DE 19518928
(43) Veröffentlichungstag der Anmeldung: 11.03.1998
(73) Patentinhaber: DAIMLER-BENZ AKTIENGESELLSCHAFT, 70546 Stuttgart (DE)
(72) Erfinder: IRREGGER, Franz, D-85764 Oberschleisseim (DE); MEISSNER, Horst, D-82256 Fürstenfeldbruck (DE); STEPHAN, Harald, D-85716 Unterschleisseim (DE)
(86) Internationale Anmeldenummer: DE9600906
(87) Internationale Veröffentlichungsnummer: WO9637839

(56) Entgegenhaltungen:
- EP-A- 0 339 286
- EP-A- 0 397 937
- DE-A- 4 100 899
- US-A- 4 977 531
- AUTOTESTCON '89 CONFERENCE RECORD; IEEE INTERNATIONAL TESTING CONFERENCE, 25. - 28.September 1989, PHILADELPHIA, PA, USA, Seiten 187-194, XP000078712 ZIEGLER ET AL.: "PROVIDING ADA BASED TEST PROGRAM AND SOFT PANEL INSTRUMENT CONTROLS"
- ELEKTRONIK, Bd. 38, Nr. 22, 27.Oktober 1989, MUNCHEN DE, Seiten 132-135, XP000070855 NIERMANN: "DIE "WAVES" SCHLAGEN HOCH"

## Beschreibung

Die Erfindung bezieht sich auf ein Verfahren gemäß dem Oberbegriff des Patentanspruchs 1. Außerdem betrifft die Erfindung einen Prüfplatz zur Durchführung dieses Verfahrens.

Bekannte rechnergesteuerte Meß- und Prüfverfahren für elektrische Schaltungen, insbesondere für elektrische Baugruppen, laufen so ab, daß für jede Meß- und Regelaufgabe jeweils ein eigenes Software-Programm geschrieben werden muß, welches sowohl Kenndaten, Treiber und Meßroutinen einschließlich Auswerteanforderungen enthält. Unter dem Begriff Prüfsoftware versteht man dabei die Software, welche erforderlich ist, um mittels rechnergestützter Meßplätze Meßgeräte zu steuern und die gemessenen Daten weiter zu verarbeiten. Die Programmierung erfolgt in den meisten Fällen produktorientiert, d.h. das entstandene Prüfprogramn ist nur für diese Einheit einsetzbar. Außerdem ist die Strukturierung vom Programmierer direkt abhängig. Die Änderung von solchen Programmen ist ausschließlich durch den Ersteller möglich. Ist der Ersteller nicht mehr einsetzbar, so muß die Software neu erstellt werden. Ein Re-Engineering ist somit nicht mehr möglich. Es ergeben sich mithin bei den bekannten rechnergesteuerten Meßund Prüfverfahren hauptsächlich folgende Nachteile: hoher Erstellungsaufwand, sehr aufwendige Änderungen, keine Sicherbarkeit des Know-hows und keine Transparenz der Programme.

Aus dem Dokument AUTUTESTCON '89 CONFERENCE RECORD, IEEE INT'L CONFERENCE, 25-28, September 1989, PHILADELPHIA, US, Seiten 187-194, ZIEGLER ET AL: "Providing ADA Based Test Program and Soft Panel Instrument Control" ist ein rechnergestütztes Prüfverfahren bekannt, in dem gewisse Änderungen des Prüfungsverfahren durch den Benützer möglich sind. Doch sind die durch den Benutzer durchführbare Änderungen des Prüfprogrammes begrenzt, in dem der Benutzer nur einige aus einem Mehrzahl von standardisierten separaten Prüffunktionen abrufen kann.

Aufgabe der Erfindung ist es, den bei rechnergestützten Meßund Prüfverfahren für elektrische Schaltungen, insbesondere elektronische Baugruppen, aufzubringenden Aufwand zu verringern, insbesondere was die Erstellung von Software für die Durchführung von Meß- und Regelaufgaben mit rechnergesteuerten Meß- und Prüfmitteln angeht.

Diese Aufgabe wird bei einem gattungsgemäßen Verfahren durch die im kennzeichnenden Teil des Patentanspruchs 1 angegebenen Merkmale gelöst. Durch die erfindungsgemäße Aufteilung der Meß- und Regelaufgaben in einen Daten- und einen Meßgerätetreiberteil läßt sich der Aufwand zur Erstellung der Software um den Faktor 3 bis 10 reduzieren. Durch die Zusammenfassung der meßaufgabenrelevanten Daten in einem Text-Datenfeld ist die Durchführung von Änderungen für jederman möglich. Das ReEngineering ist damit automatisch gegeben.

Die Prüfsoftware läßt sich produktunabhängig gestalten. Die Ausgangsgrößen aus den Prüfspezifikationen und den Prüfanweisungen werden transparent gehalten, d.h. diese Daten sind so lesbar wie das Basisdokument.

In zweckmäßiger Weise sind im Text-Datenfeld, das sich in der Rechnereinheit befindet, die Prüfspezifikationsdaten, d.h. Stimulis und Kennwerte, die Prüfanweisungsdaten, d.h. Prüfschritt-Informationen und -Anweisungen sowie ein Prüfprotokolldaten aufnehmendes Meßdatenfeld vorhanden.

Ein Prüfplatz zur Durchführung des Verfahrens nach der Erfindung ist gekennzeichnet durch die Verwendung einer Rechnereinheit als Controller und vorzugsweise mit einem Drucker, einer Meßgeräte-Peripherie mit den jeweils erforderlichen Meßgeräten, z.B. einem Digitalmultimeter, und mit Netzgeräten, und eines Prüfadapters zur Aufnahme der jeweils zur Prüfung vorgesehenen elektrischen Schaltung, insbesondere elektronischen Baugruppe, wobei das Netzgerät sowohl den Prüfadapter als auch die Meßgeräte versorgen kann und wobei zwischen den Meßgeräten und dem Prüfadapter Verbindungsleitungen bestehen. Die Treibersoftware dient dabei zum Steuern der am jeweiligen Prüfplatz zur Verfügung stehenden Meßgeräte. Alle Meßgeräte sind über einen standardisierten Datenbus untereinander und mit dem Rechner verbunden. Die Treibersoftware ist unabhängig vom verwendeten Meßplatz. Sie wird nur einmal zur Anpassung an das vereinbarte Text-Datenfeld geschrieben und enthält auch die für die Messungen erforderlichen Meßroutinen.

Im folgenden wird die Erfindung anhand von drei Figuren noch erläutert.

Es zeigen:
- Fig. 1: die schematische Ansicht eines Ausführungsbeispiels eines Prüfplatzes zur Durchführung des Verfahrens nach der Erfindung,
- Fig. 2: eine Strukturansicht zur Verdeutlichung des Verfahrens nach der Erfindung, und
- Fig. 3: ein beispielhaftes Text-Datenfeld und darunter eine ausgedruckte Auflistung von einzelnen Prüfschritten bei der Durchführung eines Prüfvorganges nach der Erfindung.

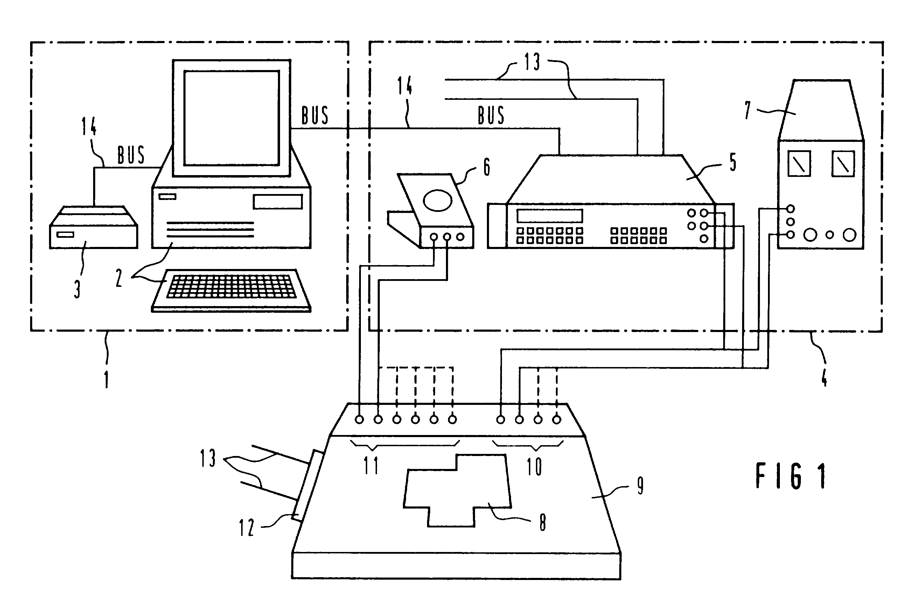

Der in Fig. 1 dargestellte Prüfplatz enthält eine Rechnereinheit 1 mit einem Rechner, der als Controller 2 bezeichnet wird, und einem Drucker 3. Des weiteren enthält der Prüfplatz eine Meßgeräte-Peripherie 4, die hier im Beispiel mit einem Digitalmultimeter als einzigem Meßgerät 5, mit einem Potentiometer als Einstellvorrichtung 6 und mit einem Netzteil 7 zur Stromversorgung ausgerüstet ist. Der Prüfling, im Beispiel eine elektronische Baugruppe 8 zu Stromversorgungszwecken, ist in einen Prüfadapter 9 eingelegt, der mit Zuführungsklemmen 10 für die Stromversorgungszuführung und Zuführungsklemmen 11 für Meß- und Einstellzwecke, im dargestellten Beispiel zum Anschließen des Potentiometers 6, versehen ist. Außerdem weist der Prüfadapter 9 eine Anschlußeinrichtung 12 für eine Steuerleitung 13 vom Meßgerät 5, im Beispiel dem Digitalmultimeter, auf. Dieses Meßgerät 5 ist über einen standardisierten Datenbus 14 mit der Rechnereinheit 1 verbunden.

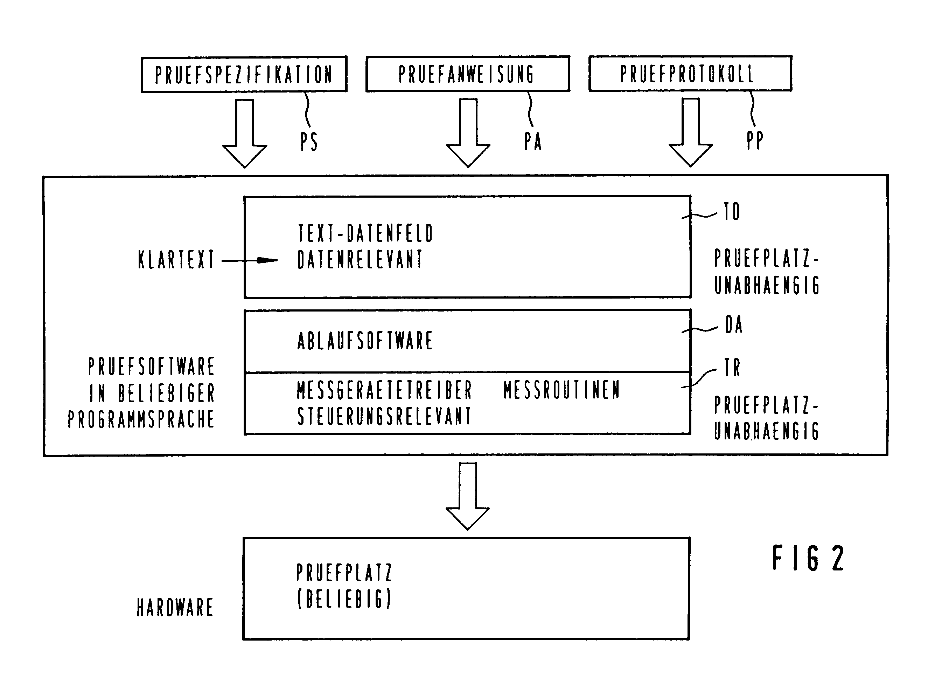

Die in Fig. 2 dargestellte prinzipielle Struktur für das Verfahren nach der Erfindung zeigt die Auftrennung der Prüfsoftware in einen ablaufrelevanten Anteil DA, der die Prüfspezifikationsdaten PS und die Prüfanweisungsdaten PA der Reihe nach aus einem Text-Datenfeld TD abruft, und einen steuerungsrelevanten Anteil TR, der den von den jeweils zu prüfenden elektronischen Baugruppen unabhängigen Treiberteil für die Meßgeräte samt deren für die Messungen erforderlichen Meßroutinen enthält. Der datenrelevante Anteil wird im Text-Datenfeld TD aufgebaut, aus welchem die steuerungsrelevanten Informationen von den Meßgerätetreibern abgegriffen werden können. Als reine Prüfsoftware verbleiben somit nur die produktunabhängigen Meßgerätetreiber und deren Meßroutinen. Der eigentliche Prüfablauf ergibt sich aus der Reihenfolge der im Text-Datenfeld TD aufeinanderfolgenden Prüfschritte. Die Struktur zeigt, daß die Prüfsoftware produktunabhängig gestaltet ist. Die Ausgangsgrößen aus den Prüfspezifikationen PS und den Prüfanweisungen PA sind transparent gehalten. Die Treibersoftware dient zum Steuern der im jeweiligen Prüfplatz zur Verfügung stehenden Meßgeräte. Sie ist unabhängig vom verwendeten Meßplatz. Sie wird nur einmal zur Anpassung an das vereinbarte Text-Datenfeld TD geschrieben und enthält auch die für die Messungen erforderlichen Meßroutinen. Die Prüfsoftware läßt sich in beliebiger Programmiersprache formulieren. Das Text-Datenfeld TD enthält am Schluß ein Meßdatenfeld für ein Prüfprotokoll PP.

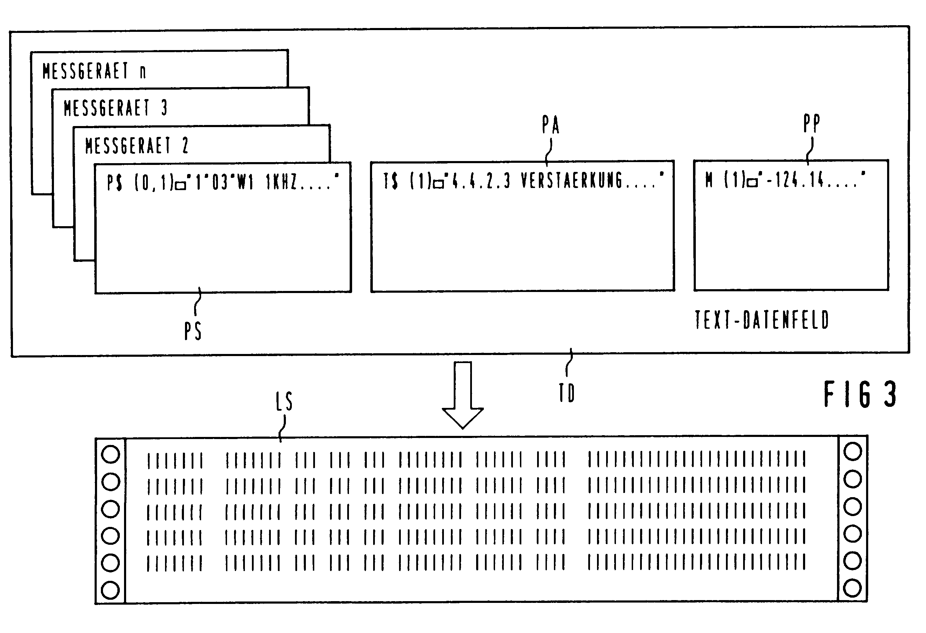

Fig. 3 zeigt ein Beispiel für ein Text-Datenfeld TD für mehrere Meßgeräte. Auf der linken Seite des Text-Datenfelds TD befinden sich die Prüfspezifikationsdaten PS mit Stimulis und Kennwerten. In der Mitte sind im Text-Datenfeld TD Prüfanweisungs-Daten PA, d.h. Prüfschritt-Informationen und -Anweisungen angeordnet. Auf der rechten Seite befindet sich ein MeßDatenfeld mit Protokoll-Daten PP. Aus den PrüfspezifikationsDaten PS auf der linken Seite des Text-Datenfelds TD läßt sich der Programmablauf, d.h. die Prüfschrittreihenfolge entnehmen. Unterhalb des in Fig. 3 dargestellten Text-Datenfelds TD ist eine Auflistung LS von einzelnen Prüfschritten des Text-Datenfeldes TD dargestellt. Diese Auflistung LS zeigt das transparente Datenfeld und kann im Drucker der verwendeten Rechnereinheit ausgedruckt werden.

Die Erfindung hat die Vorteile, daß die Prüfdateneingabe nur im Klartext erforderlich ist. Damit ergeben sich geringere Anforderungen an die Qualifikation des Personals, eine schnelle Anpassung bei Änderungen, keine Know-how-Abhängigkeit und eine Rationalisierungswirksamkeit bereits bei Stückzahlen, die geringer sind als 10.

## Patentansprüche

1. Verfahren zur rechnergestützten Messung und Prüfung von elektrischen Schaltungen (Prüflingen), insbesondere von elektronischen Baugruppen, unter Verwendung von Prüfsoftware zur Steuerung von am jeweiligen Prüfplatz zur Verfügung stehenden Meßgeräten und zur Weiterverarbeitung von gemessenen Daten,
**dadurch gekennzeichnet,**
daß die die Meß- und Regelaufgaben während des Prüfvorgangs bestimmende Prüfsoftware in einen datenrelevanten Anteil, der Prüfspezifikationsdaten (PS) und Prüfanweisungsdaten (PA) enthält, und einen steuerungsrelevanten Anteil (TR), der den von den jeweils zu prüfenden Schaltungen (Prüflingen) (8) unabhängigen Treiberteil für die Meßgeräte (5) samt deren für die Messungen erforderlichen Meßroutinen enthält, getrennt ist, daß der datenrelevante Anteil als Text-Datenfeld (TD) aufgebaut wird, aus dem die steuerungsrelevanten Informationen abgreifbar sind, daß der steuerungsrelevante Anteil der Prüfsoftware nur einmal und zwar zur Anpassung an das vereinbarte Text-Datenfeld erstellt wird, und daß sich der eigentliche, durch eine Ablaufsoftware (DA) bestimmte Prüfablauf aus der Reihenfolge der im Text-Datenfeld aufeinanderfolgenden Prüfschritte ergibt.

2. Verfahren nach Anspruch 1,
**dadurch gekennzeichnet,**
daß im Text-Datenfeld (TD), das sich in einer Rechnereinheit (1) befindet, die Prüfspezifikationsdaten (PS), d.h. Stimulis und Kennwerte, die Prüfanweisungsdaten (PA), d.h. Prüfschrittinformationen und -Anweisungen, sowie ein Prüfprotokolldaten (PP) aufnehmendes Meßdatenfeld vorhanden sind.

3. Prüfplatz zur Durchführung des Verfahrens nach Anspruch 1 oder 2,
**gekennzeichnet durch**
die Verwendung einer Rechnereinheit (1) als Controller (2) und vorzugsweise mit einem Drucker (3), einer Meßgeräte-Peripherie (4) mit den jeweils erforderlichen Meßgeräten (5), z.B. einem Digitalmultimeter, und mit Netzgeräten (7) zur Stromversorgung, und eines Prüfadapters (9) zur Aufnahme der jeweils zur Prüfung vorgesehenen elektrischen Schaltung (Prüfling) (8), wobei das Netzgerät sowohl den Prüfadapter als auch die Meßgeräte versorgen kann und wobei zwischen den Einrichtungen der Meßgeräte-Peripherie und dem Prüfadapter Verbindungsleitungen bestehen.

4. Prüfplatz nach Anspruch 3,
**dadurch gekennzeichnet,**
daß die Meßgeräte (5) untereinander und mit der Rechnereinheit (1) über einen standardisierten Datenbus (14) verbunden sind.

## Claims

1. Method for computer-aided measurement and testing of electrical circuits (units under test), in particular of electronic assemblies, using test software to control test equipment which is available at the respective test rig and for further processing of measured data,
characterized
in that the test software which defines the measurement and control tasks during the test process is split into a data-relevant element, which contains test specification data (PS) and test instruction data (PA), and a control-relevant element (TR), which contains the driver section, which is independent of the respective circuits (units under test) (8) to be tested, for the test equipment (5) together with its test routines required for the measurement, in that the data-relevant element is designed as a text data field (TD) from which the control-relevant information can be picked off, in that the control-relevant element of the test software is created only once, to be precise for matching to the agreed text data field, and in that the actual test sequence which is defined by sequence software (DA) results from the sequence of successive test steps in the text data field.

2. Method according to Claim 1,
characterized
in that the text data field (TD), which is located in a computer unit (1), contains the test specification data (PS), that is to say stimuli and characteristics, the test instruction data (PA), that is to say test step information and instructions, as well as a measurement data field which holds test record data (PP).

3. Test rig for carrying out the method according to Claim 1 or 2,
characterized by
the use of a computer unit (1) as the controller (2) and preferably having a printer (3), a test equipment peripheral (4) with the respectively required test equipment (5), for example a digital multimeter, and having power supply units (7) for the power supply, and the use of a test adapter (9) for holding an electrical circuit (unit under test) (8) which is in each case provided for testing, it being possible for the power supply unit to supply both the test adapter and the test equipment, and there being connecting lines between the devices in the test equipment peripheral and the test adapter.

4. Test rig according to Claim 3,
characterized
in that the items of test equipment (5) are connected to one another and to the computer unit (1) via a standardized databus (14).

## Revendications

1. Procédé de mesure et de vérification assisté par ordinateur de circuits électriques (éléments à vérifier), notamment de modules électroniques, utilisant un logiciel de vérification pour la commande d'appareils de mesure disponibles dans le poste de vérification considéré et pour le traitement de données mesurées,
caractérisé par le fait que le logiciel de vérification déterminant les tâches de mesure et de réglage pendant le processus de vérification est séparé en une partie concernant les données, qui contient des données de spécifications de vérification (PS) et des données d'instructions de vérification (PA), et en une partie concernant la commande (TR), qui contient la partie de gestion, indépendante des circuits à vérifier (éléments à vérifier) (8), pour les appareils de mesure (5) avec toutes leurs routines de mesure nécessaires aux opérations de mesure, que la partie concernant les données est organisée comme un champ de données de texte (TD) dans lequel les informations déterminantes pour la commande peuvent être prélevées, que la partie concernant la commande du logiciel de vérification n'est élaborée qu'une seule fois, à savoir pour l'adaptation au champ de données de texte convenu, et que l'exécution proprement dite de la vérification, déterminée par un logiciel d'exécution (DA), résulte de la succession des étapes de vérification consécutives dans le champ de données de texte.

2. Procédé selon la revendication 1,
caractérisé par le fait que le champ de données de texte (TD) qui se trouve dans une installation informatique (1) comprend les données de spécifications de vérification (PS), c'est-à-dire des stimuli et des valeurs caractéristiques, les données d'instructions de vérification (PA), c'est-à-dire des informations et des instructions d'étapes de vérification, ainsi qu'un champ de données de mesure mémorisant des données de protocole de vérification (PP).

3. Poste de vérification pour la mise en oeuvre du procédé selon la revendication 1 ou 2,
caractérisé par l'utilisation d'une installation informatique (1) comme contrôleur (2), ayant de préférence une imprimante (3), une installation périphérique d'appareils de mesure (4) comportant les appareils de mesure (5) nécessaires, par exemple un multimètre numérique, et des alimentations (7) pour l'alimentation en courant, et d'un adaptateur de vérification (9) pour loger le circuit électrique (élément à vérifier) (8) prévu pour la vérification, l'alimentation pouvant alimenter aussi bien l'adaptateur de vérification que les appareils de mesure et des lignes de communication étant prévues entre les dispositifs de l'installation périphérique d'appareils de mesure et l'adaptateur de vérification.

4. Poste de vérification selon la revendication 3,
caractérisé par le fait que les appareils de mesure (5) sont reliés entre eux et à l'installation informatique (1) par l'intermédiaire d'un bus de données (14) standard.
